# EUROPÄISCHE PATENTSCHRIFT

(11) **EP 0 568 049 B1**
(45) Veröffentlichungstag und Bekanntmachung des Hinweises auf die Patenterteilung: **24.01.1996**
(21) Anmeldenummer: 93106914.0
(22) Anmeldetag: 28.04.1993
(51) Int. Cl.: C23C 16/04, C23C 16/50, H01J 37/32

(54) **Verfahren und Einrichtung zur PECVD-Innenbeschichtung eines Hohlkörpers mittels eines Mikrowellenplasmas**
Apparatus and method for coating the inside of a hollow object by microwave-assisted plasma CVD
Dispositif et méthode pour la formation d'un revêtement sur la paroi interne d'un objet creux par CVD assisté par plasma à micro-ondes

(30) Priorität: 30.04.1992 DE 4214401; 15.12.1992 DE 4242324
(43) Veröffentlichungstag der Anmeldung: 03.11.1993
(73) Patentinhaber: Max-Planck-Gesellschaft zur Förderung der Wissenschaften e.V., D-37073 Göttingen (DE)
(72) Erfinder: Wilhelm, Rolf, Prof. Dr., W-8000 München 45 (DE); Möller, Wolfhard, Prof. Dr., W-8046 Garching (DE); Hytry, Ronny, W-8056 Neufahrn-Mintraching (DE)
(74) Vertreter: von Bezold, Dieter, Dr.

(56) Entgegenhaltungen:
- EP-A- 0 346 738
- DE-A- 3 222 189
- FR-A- 2 575 151
- US-A- 4 888 088

## Beschreibung

Die vorliegende Erfindung betrifft ein Mikrowellenplasmaverfahren zum Niederschlagen einer Schicht aus einem vorgegebenen Material auf der Innenfläche eines Hohlkörpers. Ferner betrifft die Erfindung eine Einrichtung zur Durchführung eines solchen Verfahrens.

Metallische Hohlkörper, wie Röhren, können durch Innenbeschichtung für sehr verschiedenartige Anwendungen vergütet werden. Beispiele sind Hartstoffschichten zur Verschleißreduktion bei mechanischen Bauteilen, Antikorrosionsschichten in Behältern und Röhren, die korrosive Fluide führen, oder Innenbeschichtungen von Mikrowellen-Hohlleitern, welche einen elektrischen Durchschlag bei hohen Leistungen verhindern.

Für die Herstellung solcher Schichten ist eine Reihe von Verfahren der physikalischen (PVD) oder chemischen (CVD) Abscheidung aus der Dampfphase bekannt. Ein weiteres bekanntes Verfahren ist die plasmagestützte chemische Dampfabscheidung (PECVD), bei der, wie bei der CVD, die Elemente der herzustellenden Schicht in Form von dampfförmigen Verbindungen zugeführt werden und die Zersetzung dieser Verbindungen durch ein Plasma bewirkt wird. Ein Vorteil der PECVD ist, daß die Beschichtung bei relativ niedrigen Substrattemperaturen durchgeführt werden kann und daß der Schichtaufbau durch Ionenbeschuß unterstützt wird.

Bei einem beispielsweise aus der FR-A-2 575 151 oder der DE-A-32 22 189 bekannten Verfahren wird durch die Einkopplung von Mikrowellenenergie in das zu beschichtende Rohr eine Plasmasäule erzeugt, deren Länge durch Veränderung der Mikrowellenleistung variiert wird, so daß sich am Ende der Säule, wo unverbrauchtes Gas in die Plasmazone einströmt, eine Abscheidungszone ausbildet. Dieses Verfahren hat den Nachteil, daß zur Erzeugung einer über die gesamte Länge des Hohlraums ausgehenden Plasmazone eine sehr hohe Mikrowellenleistung aufgewendet werden muß und daß die Mikrowellenleistung über einen großen Bereich variiert werden muß.

Die Anwendung von Verfahren zur plasmagestützten chemischen Dampfabscheidung metallischer Gegenstände stößt jedoch häufig auf Schwierigkeiten. Insbesondere können Hochfrequenz-Plasmaverfahren, die eine hohe Beschichtungsrate ermöglichen, oft nicht direkt eingesetzt werden, da die elektrische Leistung in längere Hohlräume nicht gleichmäßig eingekoppelt werden kann und sich ein Plasma lediglich lokal an der Einkoppelstelle ausbildet.

Um dieses Problem wenigstens in gewissen Fällen zu umgehen, ist aus dem Dokument EP 0 346 738 A ein Mikrowellenplasmaverfahren zum Niederschlagen einer Schicht auf der Innenseite eines Rohres bekannt, bei dem in einem örtlich begrenzten Bereich des Rohres, das eine das gewünschte Material liefernde Dampfatmosphäre enthält, ein Magnetfeld erzeugt wird, bei dem für die Frequenz der Mikrowellen Elektronen-Zyklotronresonanz eintritt. Der Druck, die Feldstärke des Magnetfeldes und die Leistung des Hochfrequenzfeldes werden so gewählt, daß im Bereich des Magnetfeldes eine Niederdruck-Gasentladung entsteht, die die das gewünschte Material liefernde Reaktion bewirkt, und das Magnetfeld und damit das Plasma werden längs des Rohres bewegt.

Dieses Verfahren hat sich in der Praxis gut bewährt, es ist jedoch in mehrerer Hinsicht verbesserungsbedürftig. Erstens beschränkt die Magnetspule die Abmessungen des zu beschichtenden Rohres und ihre Bewegung erfordert eine relativ aufwendige Mechanik. Außerdem können lediglich Rohre aus nichtmagnetischen Metallen mit einer Innenbeschichtung versehen werden und der Innenquerschnitt des zu beschichtenden Rohres muß eine gewisse Mindestgröße aufweisen, um eine Ausbreitung der Mikrowellen zu gewährleisten (für eine Frequenz von 2,45 GHz einige cm). Es wäre außerdem erwünscht, die Ionenenergie, die bei solchen Mikrowellen-Plasmen relativ gering ist, zu erhöhen, da sonst bestimmte Schichttypen oder -eigenschaften nicht realisiert werden können.

Die vorliegende Erfindung geht aus von einem Mikrowellen-plasmaverfahren zum Niederschlagen einer Schicht aus einem vorgegebenen Material auf der Innenseite eines länglichen Hohlraumes, der ein erstes, offenes und ein zweites Ende hat, mittels einer das vorgegebene Material liefernden plasmagestützten chemischen Dampfabscheidungsreaktion mindestens einer dampfförmigen Verbindung, bei welchem
(a) in Hohlraum eine die dampfförmige(n) Verbindung(en) enthaltene Atmosphäre mit einem unter dem Atmosphärendruck liegenden Druck erzeug wird,
(b) in das erste Ende des Hohlraumes Mikrowellenenergie eingespeist wird,
(c) in einem örtlich begrenzten Bereich Bedingungen hergestellt werden, die das Entstehen einer ein Plasma erzeugenden Niederdruck-Gasentladung fördern,
wobei der Druck, die genannten Bedingungen und die Leistung des Hochfrequenzfeldes so gewählt sind, daß in dem genannten begrenzten Bereich die Niederdruck-Gasentladung entsteht.

Der vorliegenden Erfindung liegt die Aufgabe zugrunde, ein solches Verfahren dahingehend auszugestalten, daß keine Bewegung des Magnetfeldes längs des Hohlkörpers erforderlich ist.

Diese Aufgabe wird erfindungsgemäß durch ein Verfahren der oben erwähnten Art gelöst, bei dem
(d) man einen Plasmapfropens ausgehend von dem örtlich begrenzten Bereich durch den Hohlraum zum ersten Ende, dem Einkoppelende, laufen läßt,
(e) die Einspeisung der Mikrowelle in das erste Ende unterbrochen wird und
(f) die Verfahrensschritte (c) bis (e) so oft wiederholt werden, bis ein gewünschtes Bearbeitungsergebnis erreicht ist.

Bei einer ersten Ausführunqsform des vorliegenden Verfahrens wird im Verfahrensschritt (c) in dem örtlich begrenzten Bereich ein stationäres Magnetfeld erzeugt, das die Entstehung eines Mikrowellenplasmas fördert.

Mit Hilfe dieses Verfahrens können Innenbeschichtungen in Hohlkörpern aus beliebigen metallischen Materialien, insbesondere auch ferromagnetischen Materialien, vorgenommen werden. Die Wandstärke des Hohlkörpers spielt keine Rolle, es kann also auch die Innenwand einer Bohrung in einem massiven Bauteil beschichtet werden. Bei bevorzugten Ausführungsformen können auch in engen Röhren Beschichtungen erzeugt werden, die als Hohlleiter einen für die ausbreitenden Mikrowellen zu geringen Querschnitt aufweisen. Ferner kann bei bevorzugten Ausführungsformen zusätzlich noch ein elektrisches Gleichfeld erzeugt werden, das die Ionenenergie und damit die Effektivität der Beschichtung erhöht.

Eine bevorzugte Einrichtung zur Durchführung obigen Verfahrens wird in Anspruch 4 definiert und enthält
(a) einen Mikrowellengenerator zum Erzeugen von Mikrowellen;
(b) eine Einkoppelvorrichtung zum Einkoppeln der Mikrowellen in ein erstes, offenes Ende eines mit einer Innenbeschichtung zu versehenden Hohlraumes;
(c) eine Vorrichtung zum Erzeugen eines stationären Magnetfeldes bei einem zweiten Ende des Hohlraumes und
(d) eine Vorrichtung zum Abschalten des Mikrowellengenerators wenn eine im Bereich des Magnetfeldes erzeugte Plasmaentladung zum Einkoppelende gelaufen ist.

Bei einer anderen Ausführungsform des vorliegenden Verfahrens, die auch dort verwendet werden kann, wo Maqnetfelder stören, wird das Plasma in einem gewissen, im Prinzip beliebigen Abstand vom Ort der Einkopplung der Mikrowellen in den Hohlkörper durch ein elektrisches Feld erzeugt, das eine so hohe Feldstärke hat, daß das elektrische Feld für sich allein (also ohne zusätzliches Magnetfeld) ausreicht, das Plasma zu erzeugen.

Besonders vorteilhaft ist es hier, das Plasma durch eine lokale Überhöhung der Feldamplitude des elektrischen Feldes der Mikrowelle selbst zu zünden, z.B. an einer metallischen Spitze, die in einen den erwähnten Bereich enthaltenden Hohlleiter hineinreicht, oder Blenden oder Stege im Hohlleiter, die eine Erhöhung des elektrischen Feldes im Hohlleiter bewirken.

Bevorzugten Einrichtungen zur Durchführung der zweiten Ausführungsform des erfindungsgemäßen Verfahrens werden an Ansprüchen 12 und 15 definiert und enthalten :
(a) einen Mikrowellengenerator zum Erzeugen von Mikrowellen;
(b) eine Einkoppelvorrichtung zum Einkoppeln der Mikrowellen in ein erstes, offenes Ende eines mit einer Innenbeschichtung zu versehenden Hohlraumes;
(c) eine Einrichtung zum Erzeugen einer unter vermindertem Druck stehenden Gasatmosphäre im Hohlraum;
(d) eine Vorrichtung zum Erzeugen eines elektrischen Feldes, das für sich alleine ausreicht, eine Niederdruck-Gasentladung zu erzeugen (vorzugsweise eine Vorrichtung zum Erzeugen einer örtlichen Überhöhung der Feldamplitude des elektrischen Feldes der Mikrowellen) beim oder in der Nähe des zweiten Endes des Hohlraumes und
(e) eine Vorrichtung zum Abschalten des Mikrowellengenerators wenn eine vom Bereich der Niederdruck-Gasentladung ausgehende Plasmopfropens durch den Hohlraum gelaufen ist.

Am Außenleiter und/oder dem Innenleiter können eine metallische Spitze, eine Blende oder ein Steg oder mehrere solcher Einrichtungen zur Feldüberhöhung angeordnet sein.

Vorteile dieser zweiten Ausführungsform des erfindungsgemäßen Verfahrens und der Einrichtung zu seiner Durchführung sind, daß der apparative Aufwand geringer ist, die Einrichtung einfacher und störungssicherer ist und das Verfahren und die Einrichtung auch dort verwendet werden können, wo Magnetfelder unerwünscht sind, z.B. bei der Plasmadiagnostik zur Prozeßoptimierung. Das Verfahren und die Einrichtung gemäß der Erfindung können auch zum Plasma-ätzen verwendet werden.

Bei einer speziellen Ausgestaltung beider Einrichtungen, die sich besonders für enge zylindrische Hohlräume eignet, enthält die Einkoppelvorrichtung einen Leiter, der sich in das Innere des Hohlraumes erstreckt und mit dessen Wand eine Art von Koaxialleitung bildet.

Gemäß einer besonders bevorzugten Ausführungsform dieser Art ist eine Gleichspannungsquelle vorgesehen, welche den Innenleiter bezüglich der Wand des Hohlraumes mit einer Gleichspannung vorzuspannen gestattet, um die Energie der auf die Innenwand auftreffenden Ionen zu erhöhen. Im allgemeinen wird der Innenleiter positiv bezüglich der Innenwand vorgespannt werden.

Im folgenden werden Ausführungsbeispiele der Erfindung unter Bezugnahme auf die Zeichnungen näher erläutert. Es zeigen:
- Figur 1: eine schematische Darstellung einer ersten Einrichtung zur Beschichtung der Innenwand eines länglichen Hohlraumes;
- Figur 2: eine schematische Darstellung einer zweiten Ausführungsform einer PECVD-Einrichtung, die sich insbesondere für zylindrische Hohlräume eignet, deren Querschnitt zu klein ist um als Hohlleiter für Mikrowellen wirken zu können;
- Fig. 3: eine Schnittansicht eines Körpers mit einer Bohrung, die mit einer PECVD-Innenbeschichtung zu versehen ist, und eine schematische Darstellung einer Einrichtung zur PECVD-Innenbeschichtung dieser Bohrung durch ein weiteres bevorzugtes Ausführungsbeispiel des Verfahrens gemäß der Erfindung und
- Fig. 4: eine Fig. 3 entsprechende Ansicht mit einer abgewandelten Einrichtung.

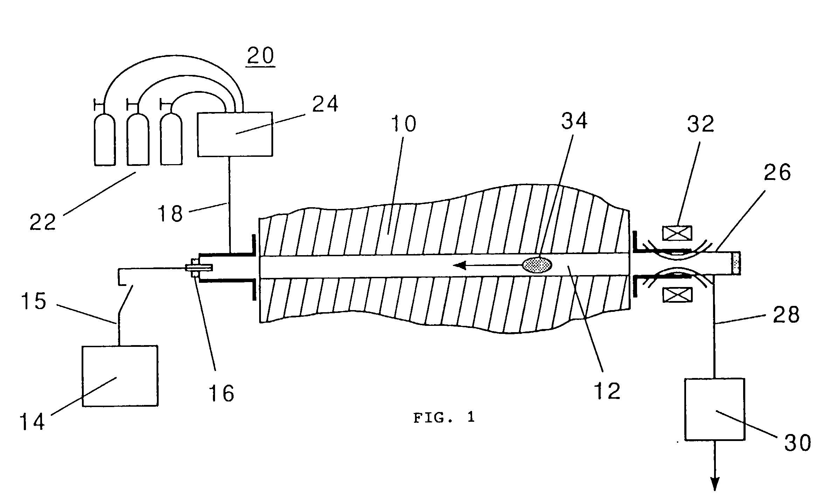

Figur 1 zeigt schematisch einen Körper 10, der eine langgestreckte zylindrische Bohrung 12 aufweist, deren Innenwand durch PECVD mit einer Beschichtung versehen werden soll. Der Körper 10 kann aus beliebigem Material, z.B. auch aus ferromagnetischem Metall bestehen, die Innenwand der Bohrung 12 soll nur eine ausreichende elektrische Leitfähigkeit aufweisen. Eine für die Beschichtunq geeignete Ausführungsform einer Einrichtung gemäß der Erfindung enthält einen Mikrowellengenerator 14, der z.B. Mikrowellen mit einer Frequenz von 2,45 GHz und einer Leistung von etwa 1 kW zu liefern vermag, eine mit dem Ausgang des Mikrowellengenerators verbundene Einkoppelvorrichtung 16, welche aus einem rohrförmiqen Hohlleiterstück besteht, das am einen Ende einen Einkoppelstift und am anderen Ende einen Flansch aufweist und das vorzugsweise den gleichen Querschnitt wie die Bohrung 12 hat. Das Hohlleiterstück ist außerdem über eine Rohrleitung 18 mit einer Arbeitsgasquelle 20 verbunden, welche mehrere Arbeitsgasbehälter 22 und eine Durchflußregelvorrichtung 24 enthält. Die Einrichtung enthält ferner ein zweites, aus nichtmagnetischem Material bestehendes Hohlleiterstück 26, dessen Querschnitt hinsichtlich Form und Abmessung vorzugsweise ebenfalls dem der Bohrung 12 entspricht und das ein mit einem Flansch versehenes offenes Ende und ein geschlossenes Ende aufweist. Das Hohlleiterstück 26 ist über eine Rohrleitung 28 mit einer Vakuumpumpe 30 verbunden. Die Einrichtung enthält schließlich noch eine Magnetspule 32, die das Hohlleiterstück 26 umgibt und in diesem ein Magnetfeld zu erzeugen gestattet, das die Entstehung einer Gasentladung fördert, insbesondere ein Magnetfeld solcher Stärke, daß bei der Frequenz der Mikrowellen Elektronen-Zyklotronresonanz eintritt.

Im Betrieb werden die Hohlleiterstücke 16 und 26, wie dargestellt, mit ihren Flanschen an ein erstes bzw. zweites Ende der beidseits offenen rohrförmigen Bohrung 12 unter Zwischenlage einer geeigneten, nicht dargestellten Dichtung vakuumdicht an das erste bzw. zweite Ende der Bohrung 12 angelegt. Dann wird die Bohrung mit den Hohlleiterstücken 16, 26 evakuiert. Anschließend wird eine geeignete Arbeitsgasmischung von der Arbeitsgasquelle 20 über die Durchflußregelvorrichtung 24 in das Hohlleiterstück 16 mit einer solchen Strömungsrate bezüglich der Saugleistung der Pumpe 30 eingespeist, daß sich in der Bohrung 12 ein Druck einstellt, bei dem die Mikrowellen vom Mikrowellengenerator 14 eine Niederdruck-Gasentladung erzeugen können. Die Magnetspule 32 wird erregt und der Mikrowellengenerator 14 wird in Betrieb gesetzt, so daß in dem von der Magnetspule umgebenen Bereich des Hohlleiterstückes 26 eine lokalisierte Niederdruck-Gasentladung zündet. Diese Gasentladung breitet sich vom Bereich des Magnetfelds ausgehend mit hoher Geschwindigkeit (ca. 10 km/s) in Form eines "Plasmapfropfens" 34 oder einer Ionisierungsfront zum Einkoppelende hin aus. Wenn die Ionisierungsfront das Einkoppelende erreicht hat, wird die Einspeisung der Mikrowellen, z.B. durch Abschalten des Mikrowellengenerators 14, für kurze Zeit, z.B. 1 ms, unterbrochen wie durch einen Schalter 15 versinnbildlicht ist. Anschließend werden erneut Mikrowellen eingepeist, es erfolgt eine erneute Zündung der Entladung im Bereich der Magnetspule 26 und der oben beschriebene Vorgang wird solange wiederholt, bis eine gewünschte Schichtdicke erreicht ist.

Mit dem oben beschriebenen Verfahren und der oben beschriebenen Einrichtung können Innenbeschichtungen in Hohlräumen von Körpern aus beliebigen metallischen Materialien, also auch ferromagnetischen Materialien, vorgenommen werden. Auch die Wandstärke des Hohlkörpers spielt keine Rolle.

Bei der in Figur 1 dargestellten Einrichtung wird das Magnetfeld durch eine Magnetspule erzeugt. Bei einer Mikrowellenfrequenz von 2,45 GHz beträgt die Feldstärke für die Elektronen-Zyklotronresonanz 87,5 mT. Das Magnetfeld kann jedoch auch durch einen oder mehrere Permanentmagnete erzeugt werden, insbesondere wenn das dem Einkoppelende entgegengesetzte zweite Ende des Hohlkörpers geschlossen ist, es sich also z.B. um eine Sackbohrung handelt. Als Permanentmagnete eignen sich insbesondere Selten-Erd-Magnete, wie SmCo und FeNdB.

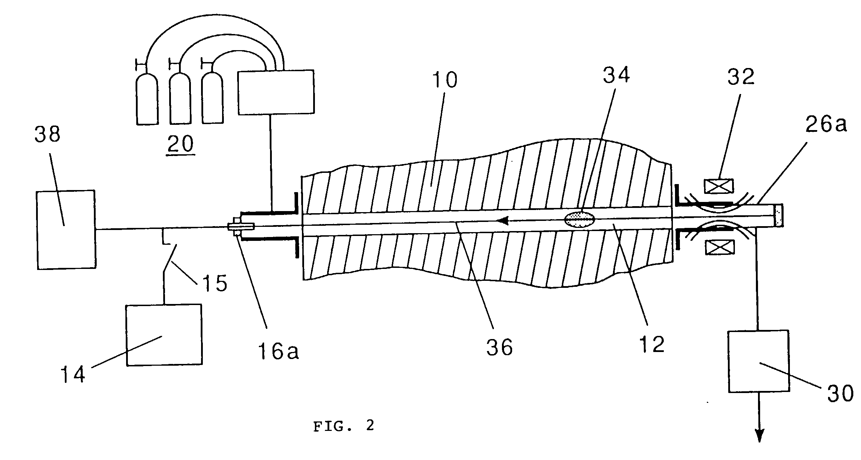

Figur 2 zeigt eine Einrichtung zur Durchführung des vorliegenden Verfahrens, die sich insbesondere für den Fall eignet, daß Rohre oder Hohlkörper mit einer Innenbeschichtung versehen werden sollen, die so eng sind, daß sich die Mikrowelle längs des langgestreckten Hohlraumes 12 nicht mehr frei ausbreiten kann. Die Einrichtung gemäß Figur 2 stimmt im wesentlichen mit der gemäß Figur 1 überein mit der Ausnahme, daß die Einkoppelvorrichtung 16a als Koaxialleiterstück mit einem Innenleiter 36 ausgebildet ist, der sich durch den mit einer Innenbeschichtung versehenen Hohlraum 12 und das nun ebenfalls als Koaxialleiter ausgebildete Rohrstück 26a am anderen Ende der Bohrung erstreckt, so daß eine Koaxialleiterstruktur gebildet wird, in der sich die Welle unabhängig von der Dimension des Hohlraumes 12 ausbreiten kann. Das Rohrstück 26a wird durch einen Isolator verschlossen, der den Leiter 36 haltert.

Diese Ausführungsform bietet weiterhin den Vorteil, daß durch eine nur schematisch dargestellte Gleichspannungsquelle 38 eine Gleichspannung zwischen den Innenleiter 36 und die zu beschichtende Wand gelegt werden kann, um die Ionenenergie zu erhöhen. Damit kann die Beschichtungsrate erhöht und/oder die Schichtqualität gezielt beeinflußt werden. Die Gleichspannungsquelle kann ein Netzgerät sein, das eine Spannung von 500 V mit 10 mA liefert. Die Verwendung des Innenleiters 36 und einer zusätzlichen Gleichspannung ist selbstverständlich nicht auf enge Hohlräume beschränkt.

Die Unterbrechung der Einspeisung der Mikrowellen kann durch einen Fühler in der Einspeisungsvorrichtung 16, 16a, der auf das Plasma anspricht, z.B. einem lichtempfindlichen Element, gesteuert werden und die Unterbrechungseinrichtung kann ein Zeitkonstantenglied enthalten, das die Dauer der Unterbrechung (z.B. größenordnungsmäßig Millisekunden), die für ein Erlöschen der Entladung und eine genügende Entionisierung ausreichen muß, bestimmt.

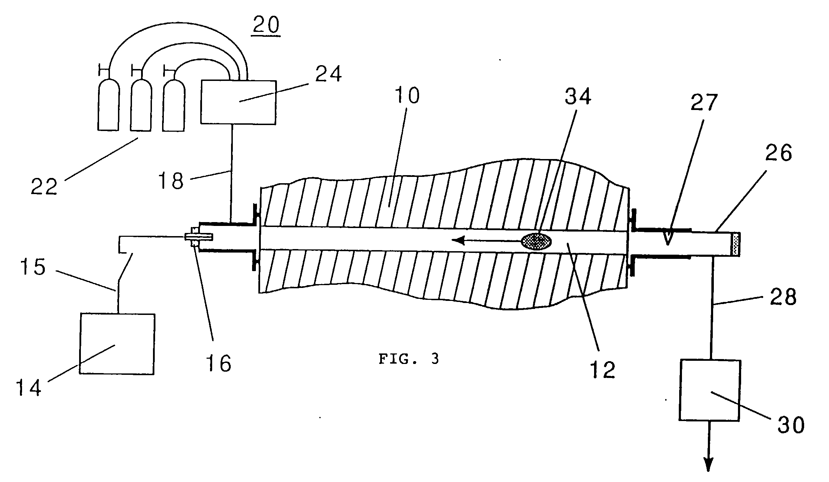

Fig. 3 zeigt wie Fig. 1 schematisch einen Körper 10, der eine langgestreckte zylindrische Bohrung 12 aufweist, deren Innenwand durch PECVD mit einer Beschichtung versehen werden soll. Der Körper 10 kann aus beliebigem Material, z.B. auch aus ferromagnetischem Metall bestehen, die Innenwand der Bohrung 12 soll nur eine ausreichende elektrische Leitfähigkeit aufweisen.

Die Einrichtung gemäß Fig. 3 enthält einen Mikrowellengenerator 14, der z.B. Mikrowellen mit einer Frequenz von 2,45 GHz und einer Leistung von etwa 1 kW zu liefern vermag, eine mit dem Ausgang des Mikrowellengenerators verbundene Einkoppelvorrichtung 16, welche aus einem rohrförmigen Hohlleisterstück besteht, das am einen Ende einen mit dem Mikrowellengenerator 14 gekoppelten Einkoppelstift und am anderen Ende einen Flansch aufweist und das vorzugsweise den gleichen Querschnitt wie die Bohrung 12 hat. Das Hohlleiterstück ist außerdem über eine Rohrleitung 18 mit einer Arbeitsgasquelle 20 verbunden, welche mehrere Arbeitsgasbehälter 22 und eine Durchflußregelvorrichtung 24 enthält. Die Arbeitsgasquelle dient dazu, eine für die PECVD-Schichterzeugung bzw. Plasmaätzung geeignete Dampf- oder Gasatmosphäre in der Bohrung 12 zu erzeugen. Die Einrichtung enthält ferner ein zweites Hohlleiterstück 26, dessen Querschnitt hinsichtlich Form und Abmessung vorzugsweise ebenfalls dem der Bohrung 12 entspricht und das ein mit einem Flansch versehenes offenes Ende und ein geschlossenes Ende aufweist. Das Hohlleiterstück 26 ist über eine Rohrleitung 28 mit einer Vakuumpumpe 30 verbunden.

Gemäß einer bevorzugten Ausführungsform der Einrichtung gemäß Fig. 3 enthält das zweite Hohlleiterstück 26 eine metallische Spitze 27, die in das Innere des Hohlleiterstückes 26 vorspringt und eine örtliche Überhöhung der Feldamplitude des elektrischen Feldes der Mikrowelle erzeugt.

Um eine örtliche Zündung des Plasmas durch die lokale Überhöhung der Feldamplitude des elektrischen Feldes der Mikrowellen zu gewährleisten, muß der Druck im Bereich der lokalen Überhöhung der Feldamplitude des elektrischen Feldes der Mikrowelle in Relation zur elektrischen Feldstärke in einem Bereich unterhalb der Zündbedingungen für die "normale", nicht überhöhte elektrische Feldamplitude gewählt werden (z.B. für E = 100 V/cm typisch ≤ 100 Pa). Der Druck darf nur soweit verringert werden, daß die "normale", nicht überhöhte elektrische Feldamplitude zur Aufrechterhaltung des Mikrowellenplasmas ausreicht. Ist dies der Fall, so zündet die Entladung lokal im Bereich überhöhten elektrischen Feldes und eine von der Mikrowelle getragene Ionisierungsfront läuft dann mit hoher Geschwindigkeit (typisch einige km/s) durch den Hohlraum zum Ort der Einkopplung der Mikrowelle. Der Mikrowellengenerator wird kurzzeitig abgeschaltet, wenn die Entladung den Ort der Einkopplung erreicht hat. Man kann auch einen gepulsten Mikrowellengenerator, z.B. mit einem Magnetron, verwenden. Man wiederholt den beschriebenen Vorgang bis zu dem angestrebten Ergebnis, also bis eine gewünschte Schichtdicke oder eine gewünschte Ätzung erreicht ist.

Die Funktion der Ausführungsform gemäß Fig. 3 beruht auf der Tatsache, daß zur Zündung eines Plasmas eine höhere elektrische Feldstärke erforderlich ist als zu seiner Aufrechterhaltung.

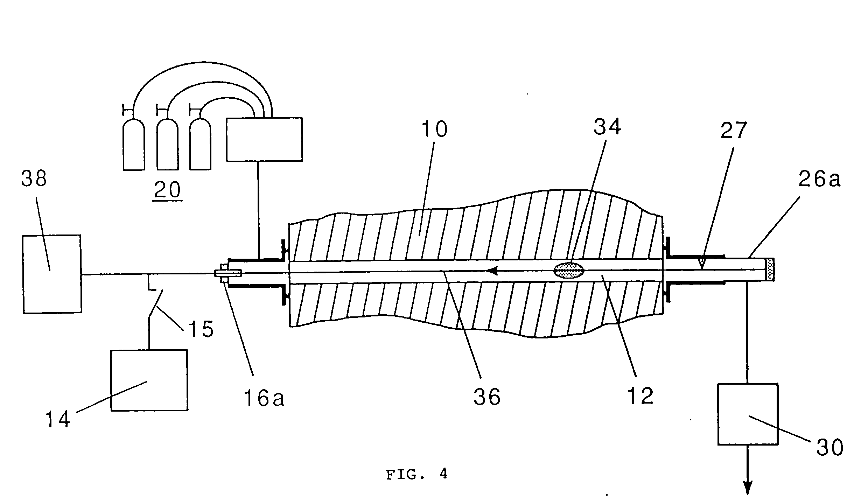

Die Einrichtung gemäß Fig. 4 eignet sich besondere für den Fall, daß die Innenwand von Rohren oder Hohlkörpern mit einer Beschichtung versehen oder geätzt werden soll, die so eng ist, daß sich die Mikrowelle längs des Hohlraums nicht mehr frei ausbreiten kann. Die Einrichtung qemäß Fig. 4 stimmt im wesentlichen mit der gemäß Fig. 3 überein mit der Ausnahme, daß die Einkoppelvorrichtung 16a als Koaxialleiterstück mit einem Innenleiter 36 ausgebildet ist, der sich durch den Hohlraum 12 und das nun ebenfalls als Koaxialleiter ausgebildete Rohrstück 26a am anderen Ende der Bohrung erstreckt, so daß eine Koaxialleitungsstruktur gebildet wird, in der sich die Mikrowelle unabhängig von der Dimension des Hohlraums 12 ausbreiten kann. Das Rohrstück 26a ist durch einen Isolator verschlossen, der den Leiter 36 haltert.

Die Ausführungsform gemäß Fig. 4 bietet weiterhin den Vorteil, daß durch eine nur schematisch dargestellte Gleichspannungsquelle 38 eine Gleichspannungzwischen den Innenleiter 36 um die zu beschichtende bzw. zu ätzende Wand gelegt werden kann, um die Ionenenergie zu erhöhen. Damit kann die Ätz- oder Beschichtungsrate erhöht und/oder die Schichtqualität gezielt beeinflußt werden. Die Gleichspannungsquelle kann ein Netzgerät sein, das eine Spannung z.B. von 500 V mit 10 mA liefert. Die Verwendung des Innenleiters 36 und einer zusätzlichen Gleichspannung ist selbstverständlich nicht auf enge Hohlräume beschränkt.

Die Unterbrechung der Einspeisung der Mikrowellen kann durch einen Fühler in der Einspeisungsvorrichtung 16, 16a, der auf das Plasma anspricht, z.B. ein lichtempfindliches Element, gesteuert werden und die Unterbrechungseinrichtung kann ein Zeitkonstantenglied enthalten, das die Dauer der Unterbrechung (z.B. größenordnungsmäßig Millisekunden) die für ein Erlöschen der Entladung und eine genügende Entionisierung ausreichen muß, bestimmt. Stattdessen, kann, wie erwähnt, auch ein gepulster Mikrowellengenerator verwendet werden, dessen Puls- und Pausendauer dann vorzugsweise einstellbar sind.

Bei einer anderen Ausführungsform der Erfindung treten an die Stelle der Spitze 27 zwei einander gegenüberliegende, isoliert gehalterte z.B. stab- oder nadelförmige Elektroden, die mit einer Spannungsquelle gekoppelt sind. Bei Anlegen einer Spannung geeigneter Größe entsteht im Bereich zwischen den Elektroden eine Niederdruck-Gasentladung, von der aus sich durch die Wirkung der Mikrowelle eine Ionisierungsfront durch den Hohlraum ausbreitet. Die Spannung an den Elektroden kann intermittierend, mit dem Beginn der Mikrowellenpulse synchronisiert angelegt werden oder auch kontinuierlich, wobei dann in dem Bereich, von dem aus sich die Ionisierungsfront durch den zu behandelnden Hohlraum ausbreitet, ein stetiges Plasma zur Verfügung steht, von dem aus sich die Ionisierungsfront beim Einschalten der Mikrowelle ausbreiten kann. Die Elektroden brauchen nicht in einem Hohlleiterstück angeordnet werden, es genügt auch z.B. eine Halterung in Form einer das betreffende Ende des zu behandelnden Hohlraums verschließenden Kappe.

## Patentansprüche

1. Mikrowellen-Plasmaverfahren zur Behandlung der Innenwand eines länglichen Hohlraums, der ein erstes offenes Ende und ein zweites Ende hat, durch Ätzen oder Niederschlagen einer Schicht aus einem vorgegebenen Material mittels eines Plasmas bei welchem
(a) im Hohlraum eine für die Behandlung geeignete Atmosphäre mit einem unter dem äußeren Atmosphärendruck liegenden Druck erzeugt wird,
(b) in das erste Ende des Hohlraums Mikrowellenenergie eingespeist wird, die sich längs des Inneren des Hohlraumes ausbreitet,
(c) in einem örtlich begrenzten Bereich Bedingungen hergestellt werden, die das Entstehen einer ein Plasma erzeugenden Niederdruck-Gasentladung fördern,
wobei der Druck, die genannten Bedingungen und die Leistung des Hochfrequenzfeldes so gewählt sind, daß in dem genannten begrenzten Bereich die Niederdruck-Gasentladung entsteht, **dadurch gekennzeichnet,** daß
(d) man einen Plasmapfropfens (34) ausgehend von dem örtlich begrenzten Bereich durch den Hohlraum zum ersten Ende, dem Einkoppelende, laufen läßt,
(e) die Einspeisung der Mikrowelle in das erste Ende unterbrochen wird und
(f) die Verfahrensschritte (c) bis (e) so oft wiederholt werden, bis ein gewünschtes Bearbeitungsergebnis erreicht ist.

2. Verfahren nach Anspruch 1, **dadurch gekennzeichnet,** daß in dem örtlich begrenzten Bereich, der sich am zweiten Ende des Hohlkörpers befindet, ein stationäres Magnetfeld erzeugt wird, das die Entstehung der Niederdruck-Gasentladung fördert.

3. Verfahren nach Anspruch 2, **dadurch gekennzeichnet,** daß die Stärke des Magnetfeldes so eingestellt wird, daß bei der Frequenz der Mikrowellen Elektronen-Zyklotronresonanz eintritt.

4. Einrichtung zur Durchführung des Verfahrens nach Anspruch 2 oder 3, mit einer Vorrichtung (20, 30) zum Erzeugen einer Atmosphäre, die mindestens eine ein gewünschtes Beschichtungsmaterial liefernde dampfförmige Verbindung enthält, mit einem unter dem Atmosphärendruck liegenden Druck in einem mit einer Innenbeschichtung aus dem vorgegebenen Material zu versehenden länglichen Hohlraum (12);
einer Vorrichtung (14, 16) zum Einspeisen von Mikrowellen in ein erstes Ende des Hohlraumes, und
einer Vorrichtung (32) zum Erzeugen eines Magnetfeldes,
**dadurch gekennzeichnet,** daß
die Vorrichtung (32) zum Erzeugen des Magnetfeldes bei einem zweiten, dem Einspeisungsende entgegengesetzten Ende des Hohlraumes (12) stationär angeordnet ist und
eine Vorrichtung (15) zum Unterbrechen der Einspeisung der Mikrowellen, wenn ein Plasmapfropfen (34) von einem im Bereich des Magnetfeldes erzeugten Plasmas zum Einkoppelende gewandert ist, vorgesehen ist.

5. Einrichtung nach Anspruch 4, **dadurch gekennzeichnet,** daß die Einkoppelvorrichtung (16) ein mit dem Mikrowellengenerator (14) gekoppeltes, vakuumdicht an das Einkoppelende des Hohlkörpers (10) anschließbares Hohlleiterstück (16) enthält und daß die Einrichtung zum Erzeugen des Magnetfeldes ein vakuumdicht an das andere Ende des Hohlkörpers anschließbares Hohlleiterstück (26) aus nicht-ferromagnetischem Material enthält.

6. Einrichtung nach Anspruch 5, **dadurch gekennzeichnet,** daß das erste Hohlleiterstück über eine Rohrleitung (18) mit einer Arbeitsgasquelle (20) verbunden ist und daß das zweite Hohlleiterstück (26) über eine Rohrleitung (18) mit einer Vakuumpumpe (30) verbunden ist.

7. Einrichtung nach Anspruch 4, **dadurch gekennzeichnet,** daß die Einkoppelvorrichtung nach Art einer Koaxialleitung ausgebildet ist und einen Innenleiter (36) enthält, der sich durch den Hohlraum (12) erstreckt.

8. Einrichtung nach einem der Ansprüche 4 bis 7, **dadurch gekennzeichnet,** daß die Einrichtung zum Erzeugen des Magnetfeldes eine Magnetspule (32) oder mindestens einen Permanentmagneten enthält.

9. Verfahren nach Anspruch 1, **dadurch gekennzeichnet,** daß in dem genannten Bereich ein elektrisches Feld mit einer für die Zündung der Niederdruck-Gasentladung ausreichenden Feldstärke erzeugt wird.

10. Mikrowellen-Plasmaverfahren nach Anspruch 9, **dadurch gekennzeichnet,** daß das Plasma in dem vorgegebenen Bereich durch eine örtliche Überhöhung der Amplitude des elektrischen Feldes der Mikrowelle gezündet wird.

11. Mikrowellen-Plasmaverfahren nach Anspruch 10, **dadurch gekennzeichnet,** daß der Druck unterhalb des Druckes gehalten wird, bei dem eine Zündung des Plasmas bei normaler nicht überhöhter elektrischer Feldstärke der Mikrowelle außerhalb des genannten Bereiches stattfinden kann.

12. Einrichtung zur Durchführung des Verfahrens nach Anspruch 10 oder 11, mit
(a) einer Vorrichtung (20, 30), um in einem Hohlraum (12), dessen Innenwand durch Plasma-Ätzen oder Beschichten zu behandeln ist, eine für die Behandlung geeignete Atmosphäre mit einem unter dem äußeren Atmosphärendruck liegenden Druck zu erzeugen,
(b) einer Vorrichtung (14, 16) zum Einspeisen von Mikrowellen in den Hohlraum (12), und
(c) einer Vorrichtung zum Erzeugen eines Plasmas in einem vorgegebenen Bereich, der mit der Atmosphäre im Hohlraum kommuniziert, und
(d) Mittel zur Beendigung des Einspeisens der Mikrowellen nachdem ein von dem Bereich ausgehender Plasmapfropfen (34) durch den Hohlraum gelaufen ist,
**dadurch gekennzeichnet,** daß
(d) die Vorrichtung zum Erzeugen des Plasmas eine Einrichtung zur örtlichen Überhöhung der elektrischen Feldstärke der Mikrowellen in dem vorgegebenen Bereich enthält, welche die Zündung bei einem Druck gewährleistet, der unter dem Druck liegt, bei dem eine Zündung durch die Mikrowellen außerhalb des genannten Bereiches, wo die elektrische Feldstärke nicht überhöht ist, möglich ist.

13. Einrichtung nach Anspruch 12, **dadurch gekennzeichnet,** daß der Hohlraum an einer der Einspeisung der Mikrowellen entgegengesetzten Seite mit einem Wellenleiterstück (16) verbunden ist, in dem sich die Einrichtung (27) zum Überhöhen der elektrischen Feldstärke der Mikrowelle befindet.

14. Einrichtung nach Anspruch 12 oder 13, **dadurch gekennzeichnet,** daß die Einrichtung zur Überhöhung der elektrischen Feldstärke mindestens eine elektrisch leitfähige Spitze (27) oder mindestens eine Blende oder mindestens einen Steg im Hohlleiter enthält.

15. Einrichtung zur Durchführung des Verfahrens nach Anspruch 9, mit
(a) einer Vorrichtung (20, 30), um in einem Hohlraum (12), dessen Innenwand durch Plasma-Ätzen oder Beschichten zu behandeln ist, eine für die Behandlung geeignete Atmosphäre mit einem unter dem äußeren Atmosphärendruck liegenden Druck zu erzeugen,
(b) einer Vorrichtung (14, 16) zum Einspeisen von Mikrowellen in den Hohlraum (12), und
(c) einer Vorrichtung zum Erzeugen eines Plasmas in einem vorgegebenen Bereich, der mit der Atmosphäre im Hohlraum kommuniziert,
**dadurch gekennzeichnet,** daß
(e) die Vorrichtung zum Erzeugen des Plasmas zwei Elektroden und eine mit diesen gekoppelte Spannungsquelle enthält, und daß
(d) Mittel zur Beendigung des Einspeisens der Mikrowellen nachdem ein von dem Bereich ausgehender Plasmapfropfen (34) durch den Hohlraum gelaufen ist, vorgesehen sind.

## Claims

1. Microwave plasma method for processing the interior wall of an elongate cavity, which has a first open end and a second end, by etching or precipitation of a layer comprising a predetermined material by means of a plasma, in which
(a) there is generated in the cavity an atmosphere suitable for the processing, with a pressure lying beneath that of the external atmosphere,
(b) microwave energy is fed into the first end of the cavity, said energy spreading along the interior or the cavity,
(c) conditions are produced in a locally restricted area, said conditions favouring the occurrence of a low pressure gas discharge generating a plasma, the pressure, the said conditions and the power of the high frequency field being so selected that the low pressure gas discharge occurs in the said restricted area,
**characterised in that**
(d) a plasma plug (34) is caused to pass through the cavity to the first, input end, starting from the locally restricted area,
(e) the input of the microwaves into the first end is interrupted, and
(f) method steps (c) to (e) are repeated until a desired processing result is achieved.

2. Method according to Claim 1, **characterised in that** there is generated in the locally restricted area, which is located at the second end of the cavity, a stationary magnetic field, which favours the occurrence of the low pressure gas discharge.

3. Method according to Claim 2, **characterised in that** the intensity of the magnetic shield is so adjusted that at the frequency of the microwaves, electron cyclotron resonance occurs.

4. Arrangement for carrying out the method according to Claim 2 or 3, with an apparatus (20, 30) for generating an atmosphere which contains at least one vaporous compound providing a desired coating material, with a pressure lying beneath atmospheric pressure in an elongate cavity (12), to be provided with an internal coating of a predetermined material;
with an apparatus (14, 16) for introducing microwaves into a first end of the cavity, and
an apparatus (32) for generating a magnetic field,
**characterised in that**
the apparatus (32) for generating the magnetic field is disposed stationarily at a second end, opposite to the input end of the cavity (12), and there is provided an apparatus (15) for interrupting the introduction of the microwaves when a plasma plug (34) has migrated from a plasma generated in the region of the magnetic field to the input end.

5. Arrangement according to Claim 4, **characterised in that** the input device (16) includes a hollow conductor member (16) coupled to the microwave generator (14) and capable of vacuum-tight connection to the input end of the hollow member (10), and in that the arrangement for generating the magnetic field includes a hollow conductor member (26) capable of vacuum-tight connection to the other end of the hollow member and comprising non-ferromagnetic material.

6. Arrangement according to Claim 5, **characterised in that** the first hollow conductor member is connected via a pipeline (18) to a source of working gas (20), and in that the second hollow conductor member (26) is connected via a pipeline (18) to a vacuum pump (30).

7. Arrangement according to Claim 4, **characterised in that** the input device is designed after the manner of a coaxial conductor, and includes an internal conductor (36) which extends through the cavity (12).

8. Arrangement according to one of Claims 4 to 7, **characterised in that** the arrangement for generating the magnetic field includes a magnet coil (32) or at least one permanent magnet.

9. Method according to Claim 1, **characterised in that** there is generated in the said area an electrical field with a field intensity sufficient to ignite the low pressure gas discharge.

10. Microwave plasma method according to Claim 9, **characterised in that** the plasma in the predetermined region is ignited by a local excess in the amplitude of the electrical field of the microwave.

11. Microwave plasma method according to Claim 10, **characterised in that** the pressure is kept beneath the pressure at which ignition of the plasma outwith the said region can take place at a normal, non-excessive electrical field intensity of the microwave.

12. Arrangement for carrying out the method according to Claim 10 or 11 with
(a) an apparatus (20, 30) for generating in a cavity (12) whose internal wall is to be treated by plasma etching or coating, an atmosphere suitable for the treatment with a pressure lying beneath the external atmospheric pressure,
(b) an apparatus (14, 16) for introducing microwaves into the cavity (12) and
(c) an apparatus for generating a plasma in a predetermined area which communicates with the atmosphere in the cavity, and
(d) means for terminating the introduction of the microwaves after a plasma plug (34) starting from said area, has passed through the cavity,
**characterised in that**
(d) the apparatus for generating the plasma includes an arrangement for providing a local excess in the electrical field intensity of the microwaves in the predetermined area, which ensures ignition at a pressure lying beneath the pressure at which ignition by the microwaves is possible outwith the said area, where the electrical field intensity is not excessive.

13. Arrangement according to Claim 12, **characterised in that** the cavity is connected at one side opposite the introduction of the microwaves to a wave guide member (16), in which there is located the arrangement (27) for providing the excess electrical field intensity of the microwave.

14. Arrangement according to Claim 12 or 13, **characterised in that** the arrangement for providing an excess of the electrical field intensity includes at least one electrically conductive point (27) or at least one diaphragm, or at least one web in the hollow conductor.

15. Arrangement for carrying out the method according to Claim 9, with
(a) an apparatus (20, 30) for generating, in a cavity (12) whose internal wall is to be treated by plasma etching or coating, an atmosphere suitable for the treatment with a pressure lying beneath the external atmospheric pressure,
(b) an apparatus (14, 16) for introducing microwaves into the cavity (12), and
(c) an apparatus for generating a plasma in a predetermined area which communicates with the atmosphere in the cavity,
**characterised in that**
(e) the apparatus for generating the plasma includes two electrodes and a voltage source connected therewith, and in that
(d) means are provided for terminating the introduction of the microwaves after a plasma plug, starting from said region, has passed through the cavity.

## Revendications

1. Procédé au plasma à micro-ondes, pour le traitement de la paroi interieure d'un espace creux allongé, ayant une première extrémité ouverte et une deuxième extrémité, par morsure chimique ou dépôt d'une couche d'un matériau prédéterminé au moyen d'un plasma, dans lequel :
(a) une atmosphère appropriée au traitement est produite dans l'espace creux, sous une pression inférieure à la pression atmosphérique extérieure,
(b) une énergie à micro-ondes, qui se propage dans la longueur du volume intérieur de l'espace creux, est injectée dans la première extrémité de l'espace creux,
(c) dans une zone limitée localement sont établies des conditions favorisant la production d'une décharge de gaz à base pression, produisant un plasma,
la pression, les conditions citées et la puissance du champ à haute fréquence étant choisies telles que la décharge de gaz à basse pression soit produite dans la zone délimitée citée, caractérisée en ce que
(d) on laisse partir un volume de plasma (34), depuis la zone localement limitée, à travers l'espace creux, vers la première extrémité, l'extrémité de couplage,
(e) on interrompt l'injection de la micro-onde dans la première extrémité, et
(f) on répète les étapes de procédé (c) à (e) à une fréquence et en un nombre de fois faisant qu'on obtient le résultat d'usinage souhaité.

2. Procédé selon la revendication 1, caractérisé en ce que dans la zone limitée localement qui se trouve à la deuxième extrémité du corps creux est produit un champ magnétique stationnaire qui favorise la production de la décharge de gaz haute pression.

3. Procédé selon la revendication 2, caractérisé en ce que l'intensité du champ magnétique est réglée à une valeur faisant qu'une résonance cyclotron des électrons se produit à la fréquence des micro-ondes.

4. Appareil de mise en oeuvre du procédé selon la revendication 2 ou 3, avec un dispositif (20, 30), conçu pour produire une atmosphère, contenant au moins une liaison vapeur fournissant un matériau de revêtement souhaité, avec une pression inférieure à la pression atmosphérique dans un espace creux (12) allongé pourvu d'un revêtement intérieur constitué du matériau prédéterminé;
un dispositif (14,16) destiné à injecter des micro-ondes dans une première extrémité de l'espace creux, et
un dispositif (32) destiné à produire un champ magnétique,
caractérisé en ce que
le dispositif (32) destiné à produire le champ magnétique est disposé de façon stationnaire à une deuxième extrémité, opposée à l'extrémité d'injection, de l'espace creux (12) et il est prévu un dispositif (15), destiné à interrompre l'injection des micro-ondes lorsqu'un volume de plasma (34), constitué d'un plasma produit dans la zone du champ magnétique, se propage vers l'extrémité du couplage.

5. Dispositif selon la revendication 4, caractérisé en ce que le dispositif de couplage (16) contient une pièce formant conducteur creux (16), couplée au générateur de micro-ondes (14), pouvant être raccordée de façon étanche au vide à l'extrémité de couplage du corps creux (10) et en ce que le dispositif destiné à produire le champ magnétique contient une pièce formant conducteur creux (26), pouvant être raccordée de façon étanche au vide à l'autre extrémité du corps creux et constituée d'un matériau non ferro-magnétique.

6. Dispositif selon la revendication 5, caractérisé en ce que la première pièce formant conducteur creux est reliée à une source de gaz de travail (20) par une conduite tubulaire (18), et en ce que la deuxième pièce formant conducteur creux (26) est reliée à une pompe à vide (30) par une l'intermédiaire d'une conduite tubulaire (18).

7. Appareil selon la revendication 4, caractérisé en ce le dispositif de couplage est réalisée à la façon d'un conducteur coaxial et contient un conducteur intérieur (36) qui s'étend à travers l'espace creux (12).

8. Appareil selon l'une des revendications 4 à 7, caractérisé en ce le dispositif destiné à produire le champ magnétique contient une bobine magnétique (32) ou au moins un aimant permanent.

9. Procédé selon la revendication 1, caractérisé en ce dans la zone citée est produit un champ magnétique ayant une intensité de champ suffisante pour amorcer la décharge de gaz basse pression.

10. Procédé au plasma à micro-ondes selon la revendication 9 , caractérisé en ce que le plasma est allumé dans la zone prédéterminée par une augmentation locale de l'amplitude du champ électrique des micro-ondes.

11. Procédé au plasma à micro-ondes selon la revendication 10, caractérisé en ce que la pression est maintenue au-dessous de la pression pour laquelle un allumage du plasma avec une intensité de champ électrique non augmentée des micro-ondes peut avoir lieu en dehors de la zone citée.

12. Appareil de mise en oeuvre du procédé selon la revendication 10 ou 11, comportant :
(a) un dispositif (20, 30), pour produire dans un espace creux (12), dont la paroi intérieure doit être traitée par morsure au plasma ou revêtement, une atmosphère convenant pour le traitement, sous une pression inférieure à la pression atmosphérique extérieure,
(b) un dispositif (14, 16) pour injecter des micro-ondes dans l'espace creux (12), et
(c) un dispositif pour produire un plasma dans une zone prédéterminée, communiquant avec l'atmosphère dans l'espace creux, et
(d) un moyen pour achever l'injection des micro-ondes après qu'un volume de plasma (34) partant de la zone indiquée ait cheminé à travers l'espace creux,
caractérisé en ce que
(e) le dispositif de production du plasma contient un dispositif d'augmentation locale de l'intensité du champ électrique des micro-ondes dans la zone prédéterminée, qui assure l'allumage pour une pression inférieure à la pression pour laquelle un allumage est possible du fait des micro-ondes, en un endroit extérieur à la zone citée, pour laquelle l'intensité de champ électrique n'a pas été augmentée.

13. Appareil selon la revendication 12, caractérisé en ce l'espace creux est relié, en un côté opposé à celui de l'injection des micro-ondes, à un élément de guide d'ondes (16) dans lequel se trouve le dispositif (27) destiné à augmenter l'intensité de champ électrique des micro-ondes.

14. Appareil selon la revendication 12 ou 13, caractérisé en ce que le dispositif d'augmentation de l'intensité de champ électrique contient au moins une pointe (27) conductrice d'électricité ou au moins un écran ou au moins une nervure ménagée dans le conducteur creux.

15. Appareil de mise en oeuvre du procédé selon la revendication 9, comportant :
(a) un dispositif (20, 30), pour produire une atmosphère convenant pour le traitement dans un espace creux (12), dont la paroi intérieure doit être traitée par morsure au plasma ou revêtement, ceci à une pression inférieure à la pression atmosphérique extérieure,
(b) un dispositif (14, 16) destiné à injecter des micro-ondes dans l'espace creux (12), et
(c) un dispositif pour produire un plasma dans une zone prédéterminée, qui communique avec l'atmosphère dans l'espace creux,
caractérisé en ce que
(e) le dispositif de production du plasma contient deux électrodes et une source de tension leur étant couplée, et en ce que
(d) des moyens sont prévus pour achever l'injection des micro-ondes après qu'un volume de plasma (34) sortant de la zone soit passé à travers l'espace creux.
